# EUROPÄISCHE PATENTSCHRIFT

(11) **EP 2 328 191 B1**
(45) Veröffentlichungstag und Bekanntmachung des Hinweises auf die Patenterteilung: **03.09.2014**
(21) Anmeldenummer: 11158098.1
(22) Anmeldetag: 18.05.2005
(51) Int. Cl.: H01L 33/62, H01L 33/64, H01L 33/58, H01L 33/60

(54) **Leuchtdiodenanordnung**
Light-emitting diode arrangement
Ensemble lumineux à diodes électroluminescentes

(30) Priorität: 30.06.2004 DE 102004031686; 22.09.2004 DE 102004045947
(43) Veröffentlichungstag der Anmeldung: 01.06.2011
(62) Teilanmeldung aus: 05753601.3
(73) Patentinhaber: OSRAM Opto Semiconductors GmbH, 93055 Regensburg (DE)
(72) Erfinder: Bogner, Georg, 93138, Lappersdorf (DE); Grötsch, Stefan, 93077, Lengfeld - Bad Abbach (DE); Wanninger, Mario, 93055, Regensburg (DE); Waitl, Günter, 93049, Regensburg (DE)
(74) Vertreter: Epping - Hermann - Fischer

(56) Entgegenhaltungen:
- US-A1- 2004 027 067

## Beschreibung

Die Erfindung betrifft eine Leuchtdiodenanordnung.

Die Druckschrift US 6,657,375 B2 beschreibt eine Leuchtdiodenanordnung, die wenigstens eine Leuchtdiode aufweist, die Licht emittiert, das aus den Seitenflächen und der Oberfläche der Leuchtdiode austritt. Dabei wird das emittierte Licht durch Leuchtstoffe, die der primären Strahlung der Leuchtdiode ausgesetzt sind, teilweise oder vollständig in langwelligere Strahlung konvertiert. Der Leuchtdiodenchip ist in eine Ausnehmung des Gehäuses angeordnet. Die Wände des Gehäuses sind reflektierend ausgebildet, und die Ausnehmung ist mit einer Vergussmasse gefüllt, welche den Leuchtdiodenchip vollständig umhüllt. Die Leuchtstoffartikel zur Konvertierung des vom Leuchtdiodenchip abgegebenen Lichts sind dieser Vergussmasse beigemischt.

Es ist Aufgabe der vorliegenden Erfindung, eine Leuchtdiodenanordnung mit besonders hoher Lichtstrahlleistung anzugeben. Diese Aufgabe wird gelöst durch eine Leuchtdiodenanordnung nach Patentanspruch 1. Vorteilhafte Ausgestaltungen der Erfindung sind Gegenstand von Unteransprüchen.

Gemäß wenigstens einer Ausführungsform der Leuchtdiodenanordnung wird eine Leuchtdiodenanordnung angegeben, die bevorzugt wenigstens einen Leuchtdiodenchip aufweist. Der Leuchtdiodenchip weist eine Strahlungsauskoppelfläche auf, über die ein Großteil der im Leuchtdiodenchip erzeugten elektromagnetischen Strahlung austritt.

Die Strahlung tritt in Richtung einer Hauptabstrahlrichtung aus. Besonders bevorzugt tritt die im Leuchtdiodenchip erzeugte Strahlung ausschließlich über die Strahlungsauskoppelfläche aus. Dabei ist die Strahlungsauskoppelfläche bevorzugt durch eine der Hauptflächen des Leuchtdiodenchips gegeben. Die Seitenflächen des Leuchtdiodenchips, die quer zu den Hauptflächen verlaufen, sind bevorzugt strahlungsundurchlässig ausgestaltet. Dabei können diese Chipflächen beispielsweise strahlungsreflektierend oder strahlungsabsorbierend ausgestaltet sein.

Weiter weist die Leuchtdiodenanordnung ein Gehäuse auf, das den Leuchtdiodenchip seitlich umschließt. Das heißt, die Seitenflächen des Leuchtdiodenchips sind von dem Gehäuse umgeben. Die Seitenflächen verlaufen vorzugsweise senkrecht oder im Wesentlichen senkrecht zur Strahlungsauskoppelfläche des Leuchtdiodenchips.

Die Leuchtdiodenanordnung weist weiterhin eine reflektive Optik auf. Die reflektive Optik ist der Strahlungsauskoppelfläche in der Hauptabstrahlrichtung nachgeordnet. Das heißt, zumindest ein Teil der vom Leuchtdiodenchip emittierten Strahlung tritt auf die reflektive Optik auf und wird von dieser reflektiert.

Die Leuchtdiodenanordnung weist also einen Leuchtdiodenchip mit einer Strahlungsauskoppelfläche auf, über die ein Großteil der im Leuchtdiodenchip erzeugten elektromagnetischen Strahlung in Hauptabstrahlrichtung austritt, ferner ein Gehäuse, das den Leuchtdiodenchip seitlich umschließt und eine reflektive Optik, die der Strahlungsauskoppelfläche in Hauptabstrahlrichtung nachgeordnet ist.

Bevorzugt enthält der Leuchtdiodenchip einen epitaktisch gewachsenen Schichtstapel. Der Schichtstapel ist beispielsweise eine Abfolge von epitaktisch gewachsenen Schichten. Bevorzugt umfasst der Schichtstapel wenigstens eine aktive Zone, die zur Erzeugung elektromagnetischer Strahlung geeignet ist. Bevorzugt ist die aktive Zone zur Erzeugung von elektromagnetischer Strahlung im blauen oder ultravioletten Spektralbereich geeignet.

Dazu kann die aktive Zone beispielsweise einen pn-Übergang, eine Doppelheterostruktur, einen Einfach-Quantentopf oder besonders bevorzugt eine Mehrfach-Quantentopfstruktur (MQW) aufweisen. Solche Strukturen sind dem Fachmann bekannt und werden daher an dieser Stelle nicht näher erläutert. Beispiele für MQW-Strukturen sind in den Druckschriften WO 01/39282, WO 98/31055, US 5,831,277, EP 1 017 113 und US 5,684,309 beschrieben, deren Offenbarungsgehalt die MQW-Strukturen betreffend hiermit durch Rückbezug aufgenommen wird.

Der Schichtstapel ist besonders bevorzugt eine Abfolge von epiktaktisch gewachsenen Schichten, von denen das Aufwachssubstrat nach Abschluss des epiktaktischen Wachstums entfernt worden ist. Besonders bevorzugt ist auf die dem ursprünglichen Aufwachssubstrat abgewandte Oberfläche des Schichtstapels ein Träger aufgebracht. Bauteile, die unter Entfernen des Aufwachssubstrats von einer epiktaktisch gewachsenen Schichtfolge hergestellt sind, werden oftmals auch mit dem Oberbegriff Dünnfilmschicht-Bauteile bezeichnet.

Ein Grundprinzip eines Dünnfilmschicht-Bauteils ist beispielsweise in I. Schnitzer at al., Appl. Phys. Lett. 63(16), 18. Oktober 1993, Seiten 2174 bis 2176, beschrieben, deren Offenbarungsgehalt bezüglich des Grundprinzips von Dünnfilmschichtbauteilen hiermit durch Rückbezug aufgenommen wird.

Ein Dünnfilmleuchtdiodenchip ist in guter Nährung eine Lambertscher Oberflächenstrahler und eignet sich von daher besonders gut beispielsweise für die Anwendung in einem Scheinwerfer.

Besonders vorteilhaft ist, dass der Träger, verglichen mit dem Aufwachssubrat, relativ frei gewählt werden kann. So kann der Träger hinsichtlich mancher Eigenschaften wie etwa Leitfähigkeit oder Stabilität für das Bauteil besser geeignet sein, als verfügbare Aufwachssubstrate, die zur Herstellung hochwertiger, epiktaktisch gewachsener Schichtfolgen engen Einschränkungen unterliegen. So muss, um hochwertige epiktaktische Schichten zu erhalten, das epiktaktisch abgeschiedene Material beispielsweise gitterangepasst zum Aufwachssubstrat sein.

Bevorzugt zeichnet sich der auf dem Schichtstapel aufgebrachte Träger durch einen an den Schichtstapel angepassten thermischen Ausdehnungskoeffizienten aus. Beispielsweise kann der Träger ein Halbleitermaterial wie Germanium, Gallium-Arsenid, Gallium-Nitrid, Silizium-Carbid und andere Materialien wie Saphir, Molybdän oder Metalle enthalten.

Außerdem zeichnet sich der Träger bevorzugt durch eine besonders gute thermische Leitfähigkeit aus, so dass die bei der Erzeugung von elektromagnetischer Strahlung in der aktiven Zone entstehende Wärme zumindest teilweise über den Träger an die Umgebung abgegeben werden kann.

Gemäß einer bevorzugten Ausgestaltung des Leuchtdiodenchips ist zwischen dem aufgebrachten Träger und dem Schichtstapel eine Spiegelschicht angeordnet. Die Spiegelschicht kann beispielsweise einen Bragg-Spiegel oder eine metallhaltige Spiegelschicht umfassen. Ein metallhaltiger Spiegel, der beispielsweise Gold, Gold-Germanium, Silber, Aluminium oder Platin enthalten kann, zeichnet sich gegenüber einem Bragg-Spiegel beispielsweise durch eine geringere Richtungsabhängigkeit der Reflektivität aus. Auch lässt sich mit metallhaltigen Spiegeln eine höhere Reflektivität als mit Bragg-Spiegeln erreichen.

In zumindest einer Ausführungsform der Leuchtdiodenanordnung ist der Leuchtdiodenchip geeignet, besonders kurze Lichtimpulse zu erzeugen. Beispielsweise ist der Leuchtdiodenchip geeignet, Blitzlicht zu erzeugen mit einer Beleuchtungsdauer von maximal 200 Millisekunden. Bevorzugt beträgt die Beleuchtungsdauer maximal 120 Millisekunden, besonders bevorzugt maximal 100 Millisekunden.

In wenigstens einer Ausführungsform der Leuchtdiodenanordnung ist der Leuchtdiodenchip geeignet, elektromagnetische Strahlung im Dauerbetrieb zu erzeugen. Bevorzugt ist der Leuchtdiodenchip geeignet, Licht von in etwa gleichbleibender Intensität für wenigstens 5 Minuten bereitzustellen. In etwa gleichbleibende Intensität bedeutet in diesem Zusammenhang, dass es zu leichten Schwankungen der Lichtintensität, etwa bedingt durch Schwankungen in der Stromversorgung oder durch thermische Effekte, kommen kann. Diese sind jedoch so gering, dass diese vom menschlichen Auge nicht wahrgenommen werden können.

Gemäß wenigstens einer Ausführungsform der Leuchtdiodenanordnung ist der Leuchtdiodenchip geeignet, sowohl Blitzlicht mit einer Beleuchtungsdauer von maximal 200 Millisekunden, bevorzugt maximal 120 Millisekunden, besonders bevorzugt maximal 100 Millisekunden zu erzeugen und im Dauerbetrieb für wenigstens fünf Minuten mit in etwa gleich bleibender Intensität elektromagnetische Strahlung abzugeben.

Entsprechend zumindest einer Ausführungsform der Leuchtdiodenanordnung weist die reflektive Optik eine Lichteingangsöffnung auf, durch die ein Großteil der im Leuchtdiodenchip erzeugten elektromagnetischen Strahlung in die reflektive Optik eintritt. Die Lichteingangsöffnung der reflektiven Optik ist dabei bevorzugt der Strahlungsauskoppelfläche des Leuchtdiodenchips in Hauptabstrahlrichtung nachgeordnet. Bevorzugt weist die Lichteingangsöffnung eine Fläche auf, die maximal zwei mal so groß, besonders bevorzugt maximal 1,05 bis 1,20 mal so groß wie die Strahlungsauskoppelfläche des Leuchtdiodenchips ist. Eine solche kleine Lichteingangsöffnung der reflektiven Optik erweist sich als besonders vorteilhaft, da sie eine signifikante Miniaturisierung der Leuchtdiodenanordnung ermöglicht.

Weist die Leuchtdiodenanordnung mehr als einen Leuchtdiodenchip auf, denen die reflektierende Optik nachgeordnet ist, so weist die Lichteintrittsöffnung bevorzugt eine Fläche auf, die maximal zwei mal so groß, besonders bevorzugt maximal 1,05 bis 1,20 mal so groß wie die die Summe der Strahlungsauskoppelflächen der Leuchtdiodenchips.

Nach wenigstens einer Ausführungsform der Leuchtdiodenanordnung weist die reflektive Optik eine Lichtausgangsöffnung auf. Durch die Lichteingangsöffnung in die reflektive Optik eingetretene elektromagnetische Strahlung verlässt die reflektive Optik bevorzugt durch die Lichtausgangsöffnung. Vorzugsweise ist die Lichtausgangsöffnung der Lichteingangsöffnung in der Hauptabstrahlrichtung der vom Leuchtdiodenchip erzeugten elektromagnetischen Strahlung nachgeordnet.

Besonders bevorzugt weist die reflektive Optik zwischen der Lichteingangsöffnung und der Lichtausgangsöffnung reflektierende Seitenwände auf. Die reflektierenden Seitenwände sind bevorzugt so ausgestaltet, dass sie zumindest einen Teil der durch die Lichteingangsöffnung eintretenden elektromagnetischen Strahlung in Richtung der Lichtausgangsöffnung hin reflektieren.

Gemäß wenigstens einer Ausführungsform der Leuchtdiodenanordnung weist die reflektive Optik Seitenwände auf, die mit einer Schicht oder Schichtenfolge, bevorzugt mit einer metallischen Schicht, versehen sind, die für ein von dem Halbleiterchip ausgesandtes Licht reflektierend sind.

In zumindest einer Ausführungsform der Leuchtdiodenanordnung ist die reflektive Optik in das Gehäuse, das den Leuchtdiodenchip seitlich umgibt, integriert. Das heißt, dass die Seitenwände der reflektiven Optik beispielsweise durch die dem Leuchtdiodenchip zugewandten Innenwände des Gehäuses gegeben sind. Dies ist beispielsweise dadurch erreicht, dass die inneren Gehäusewände reflektierend beschichtet sind. Die Beschichtung der Gehäuseinnenwände besteht dabei wiederum bevorzugt aus einer metallischen Schicht oder Schichtenfolge.

Alternativ ist der Grundkörper der reflektiven Optik vorteilhaft aus einem dielektrischen Material mit geeignetem Brechungsindex gebildet. Auf diese Weise wird über die Lichteingangsöffnung eingekoppeltes Licht durch Totalreflexion an den die Lichteingangsöffnung mit der Lichtausgangsöffnung verbindenden Wänden des Gehäuses reflektiert. Dies hat den Vorteil, dass es in der reflektiven Optik praktisch keine Lichtverluste aufgrund von Reflexionen gibt. In dieser Ausführungsform der Leuchtdiodenanordnung ergibt sich zudem vorteilhaft die Möglichkeit, dass das Gehäuse durch den Grundkörper der reflektiven Optik gebildet ist. Vorteilhaft kann die Leuchtdiodenanordnung auf diese Weise besonders kostengünstig produziert werden.

In wenigsten einer Ausführungsform der Leuchtdiodenanordnung ist die reflektive Optik derart gebildet, dass sie die Divergenz der vom Leuchtdiodenchip abgegebenen Strahlung reduziert. Das heißt, die durch die Lichteingangsöffnung in die reflektive Optik eintretende elektromagnetische Strahlung weist beim Lichteintritt eine größere Divergenz auf, als beim Lichtaustritt durch die Lichtausgangsöffnung der reflektiven Optik. Bevorzugt ist die reflektive Optik eine nicht abbildende Optik.

Gemäß zumindest einer Ausführungsform ist die reflektive Optik ein optischer Konzentrator, wobei die Lichteingangsöffnung der reflektiven Optik die eigentliche Lichtausgangsöffnung des Konzentrators ist. Besonders bevorzugt ist die reflektive Optik ein nicht-abbildender optischer Konzentrator. Verglichen mit der üblichen Anwendung eines optischen Konzentrators zum Fokussieren läuft das Licht in umgekehrter Richtung durch den optischen Konzentrator und wird somit nicht konzentriert, sondern es verlässt den Konzentrator mit verringerter Divergenz durch die Lichtausgangsöffnung.

In zumindest einer Ausführungsform der Leuchtdiodenanordnung ist die reflektive Optik zumindest teilweise nach Art eines zusammengesetzten parabolischen Konzentrators (Compound Parabolic Concentrator, CPC), eines zusammengesetzten elliptischen Konzentrators (Compound Elliptic Concentrator, CEC) eines zusammengesetzten hyperbolischen Konzentrators (Compound Hyperbolic Concentrator, CHC), oder einer TIR (Total Internal Reflection) Optik gebildet. Das heißt, die reflektierenden Seitenwände der reflektiven Optik sind zumindest teilweise in der Form eines CPC, CEC, CHC oder einer TIR gebildet. Weiterhin ist es vorteilhaft möglich, dass die reflektive Optik als eine Kombination dieser optischen Elemente gebildet ist. Eine derart gestaltete reflektive Optik ermöglicht vorteilhaft, eine effiziente Verringerung der Divergenz der vom Leuchtdiodenchip erzeugten elektromagnetischen Strahlung und somit eine wohldefinierte Abstrahlcharakteristik der Leuchtdiodenanordnung.

In wenigstens einer Ausführungsform der Leuchtdiodenanordnung weist die reflektive Optik eine Lichtausgangsöffnung auf, durch die ein Großteil der im Leuchtdiodenchip erzeugten elektromagnetischen Strahlung aus der reflektiven Optik austritt. Der Lichtausgangsöffnung der reflektiven Optik ist dabei in der Hauptabstrahlrichtung ein Abdeckkörper nachgeordnet. Bevorzugt ist dieser Abdeckkörper zumindest teilweise für die elektromagnetische Strahlung durchlässig. Der Abdeckkörper dient bevorzugt als Schutz der reflektiven Optik sowie des Leuchtdiodenchips vor Staub- und Schmutzpartikeln sowie vor mechanischer Einwirkung. Besonders bevorzugt ist der Abdeckkörper als Gehäusedeckel für die Leuchtdiodenanordnung ausgebildet. Dabei kann der Abdeckkörper vorteilhaft bei der Montage der Leuchtdiodenanordnung in ein Systemgehäuse als Führung oder Anschlag dienen, so dass er eine einfache und mechanisch stabile Montage der Leuchtdiodenanordnung in das Systemgehäuse ermöglicht. Besonders bevorzugt dient der Abdeckkörper als Führung und Anschlag.

Das heißt, die Leuchtdiodenanordnung kann beispielsweise dafür vorgesehen sein, in einer Ausnehmung eines Systemgehäuses versenkt zu werden. Der Abdeckkörper und die Ausnehmung sind dann derart einander angepasst, dass die der Abdeckkörper als Führung und/oder Anschlag bei der Montage der Leuchtdiodenanordnung fungiert.

Gemäß zumindest einer Ausführungsform der Leuchtdiodenanordnung enthält der Abdeckkörper ein optisches Element. Das heißt, in den Abdeckkörper ist bevorzugt eine Optik integriert, die zur Beugung, Brechung oder Wellenlängen-Konvertierung der aus der Lichtausgangsöffnung der reflektiven Optik austretenden elektromagnetischen Strahlung dient. Besonders bevorzugt erfüllt das optische Element wenigstens zwei dieser Aufgaben. Das optische Element ist bevorzugt eine nicht abbildende Optik.

In wenigstens einer Ausführungsform weist das optische Element eine Lichtausgangsfläche auf, die beispielsweise sphärisch oder asphärisch gewölbt sein kann. Dadurch kann eine weitere Verringerung der Divergenz der aus der Leuchtdiodenanordnung austretenden elektromagnetischen Strahlung erreicht werden.

Bevorzugt ist die Lichtausgangsfläche nach Art einer asphärischen Linse gewölbt. Das heißt, die Lichtausgangsöffnung ist eine zur Brechung des austretenden Lichtbündels dienende optische Fläche, die weder kugelförmig noch eben ist. Besonders bevorzugt kann ein derart gebildetes optisches Element eine Vielzahl von Formparametern aufweisen, wodurch etwa der Größe der Strahlungsauskoppelfläche des Leuchtdiodenchips und/oder der Lichtausgangsöffnung der reflektiven Optik Rechnung getragen werden kann. Im Gegensatz dazu sind sphärische Linsen für punktförmige Lichtquellen optimal und können bei nicht punktförmigen Lichtquellen signifikant schlechtere Eigenschaften hinsichtlich einer Verringerung der Divergenz des austretenden Lichtbündels aufweisen.

In zumindest einer Ausführungsform der Leuchtdiodenanordnung ist das optische Element nach Art einer Fresnel-Linse gebildet. Auch die Fresnel-Linse ist geeignet, die Divergenz der austretenden Strahlung zu verringern. Besonders vorteilhaft zeichnet sich die Fresnel-Linse durch ein besonders kostengünstiges Herstellungsverfahren aus.

In wenigstens einer Ausführungsform der Leuchtdiodenanordnung ist dem Leuchtdiodenchip in Hauptabstrahlrichtung ein Lumineszenz-Konversionsmaterial nachgeordnet, welches zumindest einen Teil der vom Leuchtdiodenchip emittierten elektromagnetischen Strahlung wellenlängenkonvertiert. Das Lumineszenz-Konversionsmaterial enthält vorteilhaft wenigstens eine Art von Leuchtstoffpartikeln. Dazu eignen sich beispielsweise anorganische Leuchtstoffe wie seltene Erden, dotierte Granate (beispielsweise YAG:Ce) oder organische Leuchtstoffe wie Perylen-Leuchtstoffe. Weitere geeignete Leuchtstoffe sind beispielsweise in der Druckschrift WO 98/12757 aufgeführt, deren Inhalt hinsichtlich der Leuchtstoffe durch Rückbezug aufgenommen wird.

Mit Hilfe des Lumineszenz-Konversionsmaterials kann entweder durch weitgehend vollständige Konversion einer Primärstrahlung des Leuchtdiodenchips oder durch gezielte teilweise Konversion und Mischung von Primärstrahlung und konvertierter Strahlung sichtbares Licht eines gewünschten Farbortes auf der CIE-Farbtafel, insbesondere weißes Licht erzeugt werden.

Gemäß zumindest einer Ausführungsform der Leuchtdiodenanordnung ist das Lumineszenz-Konversionsmaterial als dünne Schicht auf die Strahlungsauskoppelfläche des Leuchtdiodenchips aufgebracht. Besonders bevorzugt beträgt die Schichtdicke maximal 50 µm. Die minimale Dicke der Lumineszenz-Konversionsschicht beträgt etwa 5 µm. Die Lumineszenz-Konversionsschicht enthält dabei vorteilhaft ein Lumineszenz-Konversionsmaterial-Matrixgemisch. Die Matrix ist beispielsweise aus duroplastischen Polymeren oder Silikon gebildet. Der Gehalt an Lumineszenz-Konversionsmaterial ist vorteilhaft hoch.

Es erweist sich bei dieser Ausführungsform der Leuchtdiodenanordnung als besonders vorteilhaft, dass ein Großteil der vom Leuchtdiodenchip erzeugten elektromagnetischen Strahlung durch die Strahlungsauskoppelfläche austritt. Da die Lumineszenz-Konversionsschicht direkt auf der Strahlungsauskoppelfläche aufgebracht ist, ermöglicht diese Anordnung eine besonders effiziente und definierte Konversion der austretenden Strahlung. Das heißt, der überwiegende Anteil der aus dem Leuchtdiodenchip austretenden elektromagnetischen Strahlung wird zu Licht eines vorgebbaren Farbtons wellenlängenkonvertiert.

In wenigstens einer Ausführungsform der Leuchtdiodenanordnung ist der Strahlungsauskoppelfläche des Leuchtdiodenchips in Hauptabstrahlrichtung ein Plättchen nachgeordnet, das ein Lumineszenz-Konversionsmaterial enthält. Die Dicke des Plättchens beträgt bevorzugt maximal 200 µm. Die minimale Dicke des Plättchens beträgt vorzugsweise circa 10 µm. Das Plättchen kann beispielsweise ein Kunststoffmaterial enthalten, in das das Lumineszenz-Konversionsmaterial eingearbeitet ist. Es ist aber auch möglich, dass das Plättchen mit einer Schicht aus Lumineszenz-Konversionsmaterial beschichtet wird. Das Plättchen kann dann beispielsweise aus Glas gebildet sein. Besonders vorteilhaft ergibt sich, dass eine Leuchtdiodenanordnung mit solch einem Plättchen besonders einfach und kostengünstig hergestellt werden kann. Außerdem ergibt sich die Möglichkeit durch Austausch des Plättchens auf besonders einfache Weise den Farbort des von der Leuchtdiodenanordnung abgegebenen Lichts zu verändern.

In zumindest einer Ausführungsform der Leuchtdiodenanordnung enthält das optische Element ein Lumineszenz-Konversionsmaterial, das heißt, das optische Element verringert die Divergenz der austretenden Strahlung und trägt gleichzeitig zur Wellenlängenkonvertierung dieser Strahlung bei. Diese Ausführungsform der Leuchtdiodenanordnung ermöglicht vorteilhaft die Herstellung besonders kostengünstiger Leuchtdiodenanordnungen. Enthält das optische Element einen Kunststoff, so kann das Lumineszenz-Konversionsmaterial vorteilhaft in den Kunststoff eingearbeitet sein. Es ist aber auch möglich, dass das optische Element mit dem Lumineszenz-Konversionsmaterial beschichtet ist. Besonders vorteilhaft kann das optische Element dann aus Glas gebildet sein.

Nach wenigstens einer Ausführungsform der Leuchtdiodenanordnung enthält die reflektive Optik ein Lumineszenz-Konversionsmaterial. Das heißt, die reflektive Optik verringert die Divergenz des austretenden Lichts und trägt gleichzeitig zur Wellenlängenkonvertierung der vom Leuchtdiodenchip abgegebenen elektromagnetischen Strahlung bei. Je nach den Anforderungen an das von der Leuchtdiodenanordnung emittierte Licht, sind dabei verschiedene Anordnungen der Konzentration von Lumineszenz-Konversionsmaterial in der reflektiven Optik möglich. So kann eine besonders hohe Konzentration von Lumineszenz-Konversionsmaterial zum Beispiel im der Leuchtdiode zugewandten Bereich der reflektiven Optik vorhanden sein. Es ist aber auch möglich, dass die Konzentration von Lumineszenz-Konversionsmaterial in der Mitte im Strahlungsaustrittsbereich der reflektiven Optik besonders hoch ist. Insgesamt wird durch die Variation der Lumineszenz-Konversionsmaterial-Konzentration eine definierte Konversion der austretenden Strahlung ermöglicht.

Gemäß wenigstens einer Ausführungsform der Leuchtdiodenanordnung beträgt der Öffnungswinkel eines vom Lichtausgang der Leuchtdiodenanordnung, beispielsweise der Lichtausgangsfläche des optischen Elements, austretenden Lichtkegels maximal 35 Grad. Besonders bevorzugt beträgt der Öffnungswinkel zwischen 25 Grad und 35 Grad. Lichtkegel bedeutet in diesem Zusammenhang ein Volumen, das durch das vom Lichtausgang der Leuchtdiodenanordnung emittierte Licht ausgeleuchtet ist, wobei Bereiche ausgeschlossen sind, in denen die Helligkeit mehr als eine Größenordnung geringer ist als die maximale Helligkeit bei gleichem Abstand zum Lichtausgang. Ein Lichtkegel in diesem Sinne bezieht sich nicht auf die Form eines Kegels im mathematischen Sinne und kann demnach mehr als einen Öffnungswinkel aufweisen. Ist dies der Fall, so beziehen sich obige Angaben des Öffnungswinkels auf den maximalen Öffnungswinkel. Besonders bevorzugt ist die Leuchtdiodenanordnung dabei geeignet, eine in circa drei Meter Abstand befindliche Fläche von circa fünf bis sechs Quadratmeter Größe mit wenigstens zehn Lux auszustrahlen. Dabei finden ein oder mehrere Leuchtdiodenchips in der Leuchtdiodenanordnung Verwendung mit einer Gesamtstrahlungsauskoppelfläche von circa einem Quadratmillimeter.

In zumindest einer Ausführungsform der Leuchtdiodenanordnung weist die von der Leuchtdiodenanordnung ausgestrahlte Fläche eine rechteckige Form auf. Bevorzugt verhalten sich die Seiten der rechteckigen Fläche im Verhältnis vier zu drei zueinander.

In der Leuchtdiodenanordnung ist der Leuchtdiodenchip mit seiner der Strahlungsauskoppelfläche gegenüberliegenden Oberfläche auf einem Kühlkörper aufgebracht. Der Kühlkörper enthält beispielsweise eines der folgenden Materialien: Keramik, Halbleitermaterialien, Metalle. Vorteilhafterweise weist der Kühlkörper eine hohe thermische Leitfähigkeit auf und ist in seinem thermischen Ausdehnungskoeffizienten dem Material des Leuchtdiodenchips angepasst. Der Leuchtdiodenchip ist bevorzugt auf den Kühlkörper gelötet oder aufgeklebt. Die Klebverbindung zeichnet sich vorzugsweise durch eine hohe thermische Leitfähigkeit aus. Bevorzugt befinden sich auf der dem Leuchtdiodenchip abgewandten Oberfläche des Kühlkörpers elektrische Kontaktflächen isoliert zueinander. Die elektrischen Kontaktflächen sind vorzugsweise mit den jeweiligen Anschlüssen des Leuchtdiodenchips verbunden. Über die elektrischen Kontaktflächen kann der Leuchtdiodenchip elektrisch kontaktiert werden.

In der Leuchtdiodenanordnung ist der Kühlkörper mit seiner dem Leuchtdiodenchip abgewandten Seite auf einem Träger aufgebracht. Die Druckschrift US 2004/0027067 A2 zeigt Leuchtdiodenanordnung mit einem Leuchtdiodenchip, einem Kühlkörper und einem Träger.
In der Leuchtdiodenanordnung gemäß dieser Erfindung sind zwischen Träger und Kühlkörper Kontaktfedern aufgebracht, die mit den Kontaktflächen auf der dem Leuchtdiodenchip abgewandten Oberfläche des Kühlkörpers verbunden sind.

Die Kontaktfedern sind in einem spitzen Winkel um den Träger gebogen. Die Biegung der Kontaktfedern ist vorteilhaft so gestaltet, dass die Biegekräfte die Montageverbindung zwischen Kühlkörper und Träger nicht belasten. Bevorzugt sind die Federn auf Kühlkörper und Träger aufgelötet.

Nach wenigstens einer Ausführungsform der Leuchtdiodenanordnung betragen ihre äußeren Abmessungen wenigstens in einer Raumrichtung maximal vier Millimeter. Besonders bevorzugt betragen die äußeren Abmessungen der Leuchtdiodenanordnung in allen drei Raumrichtungen maximal vier Millimeter. Dies ermöglicht vorteilhaft den Einsatz der Leuchtdiodenanordnung in relativ kleinen Geräten.

Besonders bevorzugt ist die Verwendung der Leuchtdiodenanordnung in einem der folgenden Geräte: Handy, Videokamera, Photoapparat. In diesen Geräten kann die Leuchtdiodenanordnung sowohl als Blitzlicht als auch zur Dauerbeleuchtung von zum Beispiel Filmszenen eingesetzt werden. Besonders vorteilhaft erweist sich dabei, dass die Leuchtdiodenanordnung eine besonders effiziente Kühlung des Leuchtdiodenchips ermöglicht. Damit kann der Leuchtdiodenchip bei hohen Leistungen betrieben werden. Dies ermöglicht eine Ausleuchtung mit hoher Lichtintensität über einen langen Zeitraum, ohne dass ein Überhitzen der Leuchtdiodenanordnung eintreten kann.

Im Folgenden wird die hier beschriebene Leuchtdiodenanordnung anhand von Ausführungsbeispielen und den dazugehörigen Figuren näher erläutert.
Figur 1 zeigt eine schematische dreidimensionale Schnittansicht eines ersten Ausführungsbeispiels der hier beschriebenen Leuchtdiodenanordnung.
Figur 2 zeigt eine schematische dreidimensionale Schnittansicht eines zweiten Ausführungsbeispiels der hier beschriebenen Leuchtdiodenanordnung.
Figur 3 zeigt eine dreidimensionale Ansicht eines Ausführungsbeispiels der hier beschriebenen Leuchtdiodenanordnung.
Figur 4 zeigt eine schematische Schnittansicht eines Ausführungsbeispiels der hier beschriebenen Leuchtdiodenanordnung.
Figur 5 zeigt eine schematische Schnittansicht eines weiteren Ausführungsbeispiels der hier beschriebenen Leuchtdiodenanordnung.

In den Ausführungsbeispielen und Figuren sind gleiche oder gleichwirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

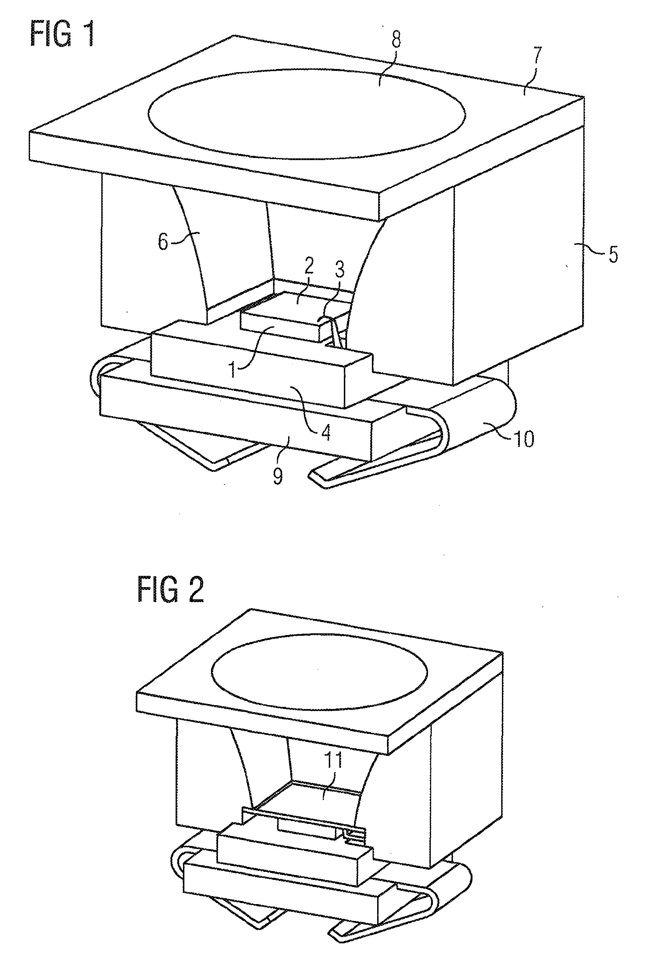

Figur 1 zeigt eine schematische dreidimensionale Schnittansicht eines ersten Ausführungsbeispiels der hier beschriebenen Leuchtdiodenanordnung.

Beim Leuchtdiodenchip 1 der Leuchtdiodenanordnung handelt es sich bevorzugt um einen Leuchtdiodenchip 1 in Dünnfilmbauweise, wie er im allgemeinen Teil der Beschreibung beschrieben ist. Der Leuchtdiodenchip 1 zeichnet sich vor allem durch seine vorteilhaft kleine Étendue aus.

Die von der aktiven Zone des Leuchtdiodenchip 1 erzeugte elektromagnetische Strahlung tritt größtenteils durch die Strahlungsauskoppelfläche 2 aus. Die Größe der Strahlungsauskoppelfläche beträgt in etwa einen Quadratmillimeter.

Der Strahlungsauskoppelfläche 2 in der Hauptabstrahlrichtung des Leuchtdiodenchips 1 nachgeordnet, ist beispielsweise eine Schicht aus Lumineszenz-Konversionsmaterial, die auf die Strahlungsauskoppelfläche 2 aufgebracht ist (nicht dargestellt). Durch die Lumineszenz-Konversionsmaterialschicht wird das aus der Strahlungsauskoppelfläche 2 austretende Licht zumindest teilweise wellenlängenkonvertiert. Bevorzugt entsteht dabei durch Lichtmischung der vom Leuchtdiodenchip emittierten Primärstrahlung und dem wellenlängenkonvertierten Teil der Strahlung weißes Licht.

Die Lumineszenz-Konversionsschicht enthält vorteilhaft ein Lumineszenz-Konversionsmaterial-Matrixgemisch. Die Matrix ist beispielsweise aus duroplastischen Polymeren wie Epoxymaterialien oder Silikonmaterialien gebildet. Der Gehalt an Lumineszenz-Konversionsmaterial ist vorteilhaft hoch. Besonders bevorzugt ist der Matrix zwischen 30 und 50 Volumenprozent Leuchtstoffmaterial beigemischt.

Zum Beispiel seitlich auf der Strahlungsauskoppelfläche 2 ist ein Bondpad 3 aufgebracht, über das der Chip elektrisch kontaktiert werden kann.

Mit seiner der Strahlungsauskoppelfläche 2 gegenüberliegenden Hauptfläche ist der Leuchtdiodenchip 1 auf dem Kühlkörper 4 aufgebracht. Der Kühlkörper 4 dient bevorzugt als Wärmesenke. Er enthält beispielsweise ein keramisches Material wie beispielsweise Al\N, ein Halbleitermaterial wie beispielsweise Silizium oder einen Metallverbund. Vorteilhaft kann der Kühlkörper 4 auch eine Kombination dieser Materialien enthalten. Der Leuchtdiodenchip 1 ist auf den Kühlkörper 4 vorzugsweise aufgelötet oder hochthermisch leitfähig geklebt. Der Kühlkörper 4 dient zur Aufnahme und Weitergabe der vom Leuchtdiodenchip 1 im Betrieb erzeugten Wärme. Bevorzugt enthält der Kühlkörper 4 Durchkontaktierungen (Vias), zum elektrischen Kontaktieren des Leuchtdiodenchips 1.

Auf den Kühlkörper 4 ist ein Gehäuse 5 aufgebracht, das den Leuchtdiodenchip 1 seitlich umgibt. Vorzugsweise umschließt das Gehäuse den Leuchtdiodenchip 1 dabei seitlich komplett. Das Gehäuse 5 kann dabei wenigstens eines der folgenden Materialien enthalten: Al₂O₃, AlN, ZO, FeNi, Kovar, Cu, Molybdän, LCP, PPA, PEEK.

In die Innenwände des Gehäuses 5 integriert, auf die Innenwände des Gehäuses 5 aufgebracht oder durch die Innenwände des Gehäuses gebildet ist eine reflektive Optik 6, die geeignet ist, das vom Leuchtdiodenchip abgegebene und gegebenenfalls wellenlängenkonvertierte Licht zu reflektieren und die Divergenz der austretenden Strahlung dabei zu verringern. Bevorzugt ist die reflektive Optik 6 dabei nach Art eines CPC, CEC, CHC, einer TIR (total internal reflection) Optik oder einer Kombination dieser optischen Elemente gebildet. Bevorzugt ist die reflektive Optik eine nicht abbildende Optik.

Dem Gehäuse 6 ist ein Abdeckkörper 7 nachgeordnet, in den ein optisches Element 8 integriert ist, das durch eine nicht abbildende Optik gebildet ist. Das optische Element ist ebenfalls geeignet, die Divergenz der aus der Leuchtdiodenanordnung austretenden Strahlung zu reduzieren.

Auf der dem Leuchtdiodenchip 1 abgewandten Oberfläche des Kühlkörpers 4 sind ein Träger 9 und Kontaktfedern 10 aufgebracht. Auch der Träger 9 dient zur Ableitung der vom Leuchtdiodenchip im Betrieb erzeugten Wärme und zeichnet sich durch eine hohe thermische Leitfähigkeit aus. Vorteilhaft kann der Leuchtdiodenchip 1 mit Strömen zwischen 0,5 und 1,0 Ampere betrieben werden. Aufgrund der effizienten Kühlung kann der Leuchtdiodenchip auch für längere Zeiten elektromagnetische Strahlung hoher Intensität abgeben, ohne dass eine Überhitzung der Anordnung auftreten kann. Der Träger 9 enthält dazu bevorzugt ein elektrisch isolierendes Material oder besteht aus einem solchen. Besonders bevorzugt enthält der Träger beispielsweise Kunststoffe oder Kohlefaser gefüllte Kunststoffe.

Die Kontaktfedern 10 enthalten beispielsweise CuFe₂P oder CuBe und dienen beispielsweise als Wärmeleitelemente zum Abführen von vom Leuchtdiodenchip 1 im Betrieb erzeugter Wärme. Außerdem ist es möglich, dass der Leuchtdiodenchip 1 mittels der Kontaktfedern 10 elektrisch kontaktiert werden kann. Träger 9 und Federn 10 erlauben zusätzlich einen Höhenausgleich bei der Montage der Leuchtdiodenanordnung in ein Systemgehäuse. Das heißt, durch Anpassung beispielsweise der Dicke des Trägers 9 und/oder dem Winkel in dem die Federn 10 um den Träger 9 gebogen sind und/oder der Länge der Federn 10, kann die Leuchtdiodenanordnung an die Tiefe einer Ausnehmung im Systemgehäuse angepasst sein.

Figur 2 zeigt eine Leuchtdiodenanordnung, die sich dadurch von dem eben beschriebenen Ausführungsbeispiel unterscheidet, dass statt einer Konversionsschicht auf der Strahlungsauskoppelfläche 2 des Leuchtdiodenchips 1 ein Plättchen 11 der Strahlungsauskoppelfläche 2 nachgeordnet ist. Dieses Plättchen 11 kann beispielsweise ein Kunststoffmaterial enthalten, dem ein Lumineszenz-Konversionsmaterial beigemengt ist oder aus einem Glasplättchen bestehen, das an einer seiner beiden Hauptflächen, die parallel zur Strahlungsauskoppelfläche 2 verlaufen, mit einem Lumineszenz-Konversionsmaterial beschichtet ist. Das Plättchen dient zur Wellenlängenkonvertierung wenigstens eines Teils der vom Leuchtdiodenchip 2 abgegebenen elektromagnetischen Strahlung.

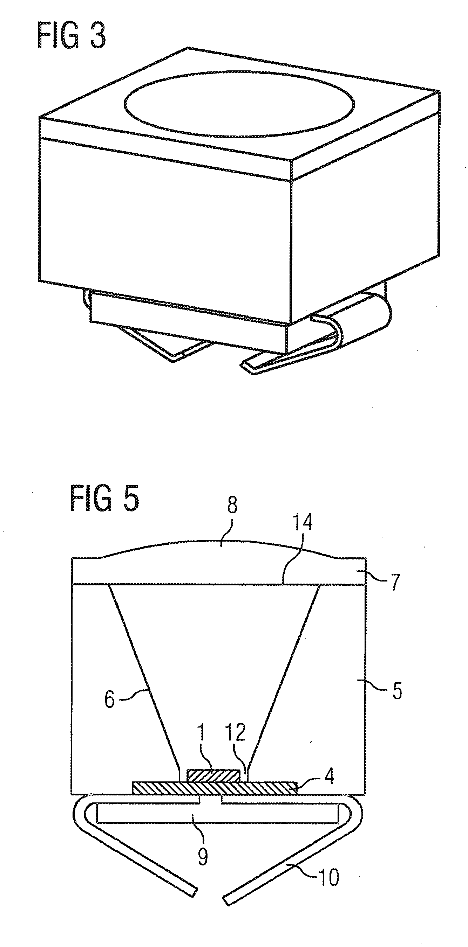

Figur 3 zeigt die Leuchtdiodenanordnung mit allen vier Seitenwänden geschlossen. Die Abmessungen der Leuchtdiodenanordnung betragen vorzugsweise circa 4x4x4 Millimeter. Aufgrund dieser kleinen Abmessungen kann die Leuchtdiodenanordnung vorteilhaft zum Beispiel auch in relativ kleinen elektronischen Geräten wie Fotohandys oder Digitalkameras eingesetzt werden.

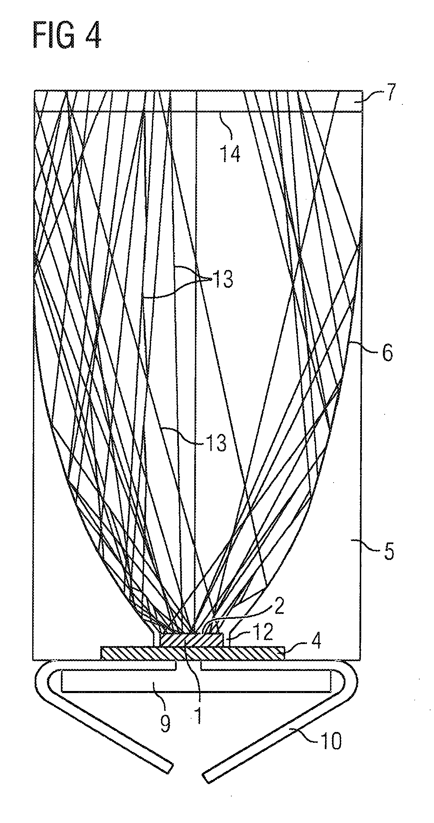

Figur 4 zeigt ein Ausführungsbeispiel der Leuchtdiodenanordnung in einer Schnittansicht. Aus der Strahlungsauskoppelfläche 2 tritt die im Leuchtdiodenchip 1 erzeugte elektromagnetische Strahlung 13 in die reflektierende Optik 6 ein, die hier als ein CPC-artiger optischer Konzentrator gebildet ist. Der CPC-artige optische Konzentrator zeichnet sich durch seine parabolisch geformten Seitenflächen aus. Der optische Konzentrator wird in umgekehrter Richtung zum Verringern der Divergenz der vom Leuchtdiodenchip 1 emittierten Strahlung 13 verwendet. Das heißt, die Lichteingangsöffnung 12 der reflektiven Optik 6 ist die eigentliche Lichtausgangsöffnung des optischen Konzentrators, wohingegen die Lichtausgangsöffnung 14 der reflektiven Optik 6 die eigentliche Lichteingangsöffnung des optischen Konzentrators ist. Die reflektive Optik ist hier beispielsweise durch eine reflektive Beschichtung gebildet, die aus einer Schicht oder einer Schichtenfolge zum Beispiel aus einer Metallschicht aus Silber gebildet ist.

Figur 5 zeigt ein weiteres Ausführungsbeispiel der Leuchtdiodenanordnung in einer Schnittansicht.

Die reflektierende Optik 6 weist hier Seitenwände auf, die in gerader Linie von der Lichteingangsöffnung 12 des optischen Elements 6 zur Lichtausgangsöffnung 14 des optischen Elements 6 verlaufen.

Die Seitenwände des optischen Elements sind dabei beispielsweise reflektierend beschichtet. In diesem Ausführungsbeispiel der Leuchtdiodenanordnung bilden die Seitenwände der reflektierenden Optik 6 also einen Pyramiden-oder Kegelstumpf. Die Seitenwände des optischen Elements 6 können dabei beispielsweise reflektierend beschichtet sein.

Zusätzlich ist der Lichtausgangsöffnung 14 der reflektierenden Optik 6 ein zweites optisches Element 8 nachgeordnet, das nach Art einer sphärischen oder asphärischen Linse nach außen gewölbt ist und zusätzlich geeignet ist die Divergenz der austretenden elektromagnetischen Strahlung zu verringern.

Alternativ zu reflektierend beschichteten Seitewänden kann die reflektierende Optik 6 ein ein dielektrisches Material enthaltender Vollkörper sein. Das Material des Vollkörpers weist dabei beispielsweise einen Brechungsindex auf, so dass über die Lichteingangsöffnung 12 eingekoppelte elektromagnetische Strahlung durch Totalreflektion an seitlichen Grenzflächen des Vollkörpers zum umgebenden Medium reflektiert wird. Dabei ist es insbesondere auch möglich, dass das zweite optische Element 8 durch eine nach außen gewölbte Grenzfläche des Vollkörpers gebildet ist. Bei diesem Ausführungsbeispiel ist es insbesondere möglich, dass der Leuchtdiodenchip 1 mit dem dielektrischen Material umgossen ist.

## Patentansprüche

1. Leuchtdioden-Anordnung, aufweisend
- wenigstens einen Leuchtdiodenchip (1) mit einer Strahlungsauskoppelfläche (2), über die ein Großteil der im Leuchtdiodenchip (1) erzeugten elektromagnetischen Strahlung (13) in einer Hauptabstrahlrichtung austritt;
- ein Gehäuse (5), das den Leuchtdiodenchip (1) seitlich umschließt sowie
- eine reflektive Optik (6), die der Strahlungsauskoppelfläche (2) in der Hauptabstrahlrichtung nachgeordnet ist, wobei
- der Leuchtdiodenchip (1) mit seiner der Strahlungsauskoppelfläche (2) gegenüberliegenden Oberfläche auf einem Kühlkörper (4) aufgebracht ist, wobei
- der Kühlkörper (4) mit seiner dem Leuchtdiodenchip (1) abgewandten Oberfläche auf einen Träger (9) aufgebracht ist,
- am Träger (9) Kontaktfedern (10) befestigt sind,
**dadurch gekennzeichnet, dass**
- zumindest Teile einer Kontaktfeder (10) zwischen Kühlkörper (4) und Träger (9) angeordnet sind, und die Kontaktfeder (10) in einem spitzen Winkel um den Träger (9) gebogen ist.

2. Leuchtdioden-Anordnung nach Anspruch 1,
bei der die Kontaktfedern (10) auf den Kühlkörper (4) und den Träger (9) aufgelötet sind.

3. Leuchtdioden-Anordnung nach einem der Ansprüche 1 oder 2,
bei der der Leuchtdiodenchip (1) ein Dünnfilmleuchtdiodenchip ist.

4. Leuchtdioden-Anordnung nach einem der vorherigen Ansprüche,
bei der dem Leuchtdiodenchip (1) in Hauptabstrahlrichtung ein Lumineszenz-Konversionsmaterial nachgeordnet ist, welches zumindest einen Teil der vom Leuchtdiodenchip (1) emittierten elektromagnetischen Strahlung wellenlängenkonvertiert.

5. Leuchtdioden-Anordnung nach Anspruch 4,
bei der das Lumineszenz-Konversionsmaterial als Schicht auf die Strahlungsauskoppelfläche (2) aufgebracht ist, wobei die Schichtdicke maximal 50 µm beträgt.

6. Leuchtdioden-Anordnung nach Anspruch 4,
bei der ein Plättchen (11), das das Lumineszenz-Konversionsmaterial enthält, der Strahlungsauskoppelfläche (2) nachgeordnet ist, wobei die Dicke des Plättchens (11) maximal 200 µm beträgt.

7. Leuchtdioden-Anordnung nach einem der vorherigen Ansprüche,
bei der ein Öffnungswinkel eines aus der Leuchtdioden-Anordnung austretenden Lichtkegels maximal 35° beträgt.

8. Leuchtdioden-Anordnung nach einem der vorherigen Ansprüche,
bei der der Kühlkörper (4) Durchkontaktierungen aufweist.

9. Leuchtdioden-Anordnung nach einem der vorherigen Ansprüche,
bei der die dem Leuchtdiodenchip (1) abgewandten Oberfläche des Kühlkörpers (4) Kontaktflächen aufweist.

10. Leuchtdioden-Anordnung nach einem der vorherigen Ansprüche,
bei der die Kontaktfedern (10) wenigstens eines der folgenden Materialien enthalten: CuFe₂P, CuBe.

11. Leuchtdioden-Anordnung nach einem der vorherigen Ansprüche,
bei der das Gehäuse (5) auf dem Kühlkörper (4) befestigt ist.

12. Leuchtdioden-Anordnung nach einem der vorherigen Ansprüche,
bei der das Gehäuse (5) wenigstens eines der folgenden Materialien enthält: Al₂O₃, AlN, ZO, FeNi, Kovar, Cu, Molybdän, LCP, PPA, PEEK.

13. Leuchtdioden-Anordnung nach einem der vorherigen Ansprüche,
bei der der Kühlkörper (4) ein keramisches Material, ein Halbleitermaterial oder einen Metallverbund enthält.

14. Leuchtdioden-Anordnung nach einem der vorherigen Ansprüche,
bei der die äußeren Abmessungen der Leuchtdioden-Anordnung maximal 4x4x4 mm betragen.

## Claims

1. Light-emitting diode arrangement, having:
- at least one light-emitting diode chip (1) comprising a radiation output surface (2), via which a large proportion of the electromagnetic radiation (13) generated in the light-emitting diode chip (1) exits in a main emission direction;
- a housing (5), which laterally surrounds the light-emitting diode chip (1), and
- a reflective optical element (6), which is arranged downstream of the radiation output surface (2) in the main emission direction, wherein
- the light-emitting diode chip (1) is applied, with its surface opposite the radiation output surface (2), to a cooling body (4), wherein
- the cooling body (4) is applied, with its surface remote from the light-emitting diode chip (1), to a mount (9),
- contact springs (10) are fastened on the mount (9),
**characterized in that**
- at least parts of a contact spring (10) are arranged between the cooling body (4) and the mount (9), and the contact spring (10) is bent at an acute angle around the mount (9).

2. Light-emitting diode arrangement according to Claim 1, in which the contact springs (10) are soldered onto the cooling body (4) and the mount (9).

3. Light-emitting diode arrangement according to either of Claims 1 and 2, in which the light-emitting diode chip (1) is a thin-film light-emitting diode chip.

4. Light-emitting diode arrangement according to one of the preceding claims, in which a luminescence conversion material is arranged downstream of the light-emitting diode chip (1) in the main emission direction, said luminescence conversion material converting the wavelength of at least some of the electromagnetic radiation emitted by the light-emitting diode chip (1).

5. Light-emitting diode arrangement according to Claim 4, in which the luminescence conversion material is applied as a layer to the radiation output surface (2), wherein the layer thickness is at most 50 µm.

6. Light-emitting diode arrangement according to Claim 4, in which a platelet (11) containing the luminescence conversion material is arranged downstream of the radiation output surface (2), wherein the thickness of the platelet (11) is at most 200 µm.

7. Light-emitting diode arrangement according to one of the preceding claims, in which an opening angle of a light cone emerging from the light-emitting diode arrangement is at most 35°.

8. Light-emitting diode arrangement according to one of the preceding claims, in which the cooling body (4) has vias.

9. Light-emitting diode arrangement according to one of the preceding claims, in which that surface of the cooling body (4) which is remote from the light-emitting diode chip (1) has contact faces.

10. Light-emitting diode arrangement according to one of the preceding claims, in which the contact springs (10) contain at least one of the following materials: CuFe₂P, CuBe.

11. Light-emitting diode arrangement according to one of the preceding claims, in which the housing (5) is fastened on the cooling body (4).

12. Light-emitting diode arrangement according to one of the preceding claims, in which the housing (5) contains at least one of the following materials: Al₂O₃, AlN, ZO, FeNi, Kovar, Cu, molybdenum, LCP, PPA, PEEK.

13. Light-emitting diode arrangement according to one of the preceding claims, in which the cooling body (4) contains a ceramic material, a semiconductor material or a metal composite.

14. Light-emitting diode arrangement according to one of the preceding claims, in which the external dimensions of the light-emitting diode arrangement are 4x4x4 mm at most.

## Revendications

1. Dispositif à diodes électroluminescentes comprenant :
- au moins une puce de diode électroluminescente (1) comportant une surface de sortie de rayonnement (2) par l'intermédiaire de laquelle une majeure partie du rayonnement électromagnétique (13) généré dans la puce de diode électroluminescente (1) est émise dans une direction de rayonnement principale ;
- un boîtier (5) qui entoure latéralement la puce de diode électroluminescente (1), et
- une optique réfléchissante (6), qui est disposée de manière adjacente à la surface de sortie de rayonnement (2) dans la direction de rayonnement principale, dans lequel
- la puce de diode électroluminescente (1) est appliquée sur un corps de refroidissement (4) par sa surface tournée vers la surface de sortie de rayonnement (2), dans lequel
- le corps de refroidissement (4) est appliqué par l'intermédiaire de sa surface opposée à la puce de diode électroluminescente (1) sur un support (9),
- des ressorts de contact (10) sont fixés au support (9),
**caractérisé en ce que**
- au moins certaines parties d'un ressort de contact (10) sont disposées entre le corps de refroidissement (4) et le support (9), et le ressort de contact (10) est replié en formant un angle aigu autour du support (9) .

2. Dispositif de diode électroluminescente selon la revendication 1, dans lequel les ressorts de contact (10) sont soudés au corps de refroidissement (4) et au support (9).

3. Dispositif de diode électroluminescente selon l'une quelconque des revendications 1 ou 2, dans lequel la puce de diode électroluminescente (1) est une puce de diode électroluminescente à couches minces.

4. Dispositif de diode électroluminescente selon l'une quelconque des revendications précédentes, dans lequel la puce de diode électroluminescente (1) est disposée en aval, dans la direction de rayonnement principale, d'un matériau de conversion de luminescence qui convertit en longueur d'onde au moins une partie du rayonnement électromagnétique émis par la puce de diode électroluminescente (1).

5. Dispositif de diode électroluminescente selon la revendication 4, dans lequel le matériau de conversion de luminescence est appliqué sur la surface de sortie de rayonnement (2) sous la forme d'une couche, l'épaisseur de couche étant au maximum de 50 µm.

6. Dispositif de diode électroluminescente selon la revendication 4, dans lequel une plaquette (11) contenant le matériau de conversion de luminescence est disposée en aval de la surface de sortie de rayonnement (2), l'épaisseur de la plaquette (11) étant au maximum de 200 µm

7. Dispositif de diode électroluminescente selon l'une quelconque des revendications précédentes, dans lequel un angle d'ouverture d'un cône de lumière sortant du dispositif de diode électroluminescente est au maximum de 35°.

8. Dispositif de diode électroluminescente selon l'une quelconque des revendications précédentes, dans lequel le corps de refroidissement (4) comprend des trous d'interconnexion.

9. Dispositif de diode électroluminescente selon l'une quelconque des revendications précédentes, dans lequel la surface du corps de refroidissement (4) qui est opposée à la puce de diode électroluminescente (1) comprend des surfaces de contact.

10. Dispositif de diode électroluminescente selon l'une quelconque des revendications précédentes, dans lequel les ressorts de contact (10) contiennent au moins l'un des matériaux suivants : CuFe₂P, CuBe.

11. Dispositif de diode électroluminescente selon l'une quelconque des revendications précédentes, dans lequel le boîtier (5) est fixé au corps de refroidissement (4).

12. Dispositif de diode électroluminescente selon l'une quelconque des revendications précédentes, dans lequel le boîtier (5) contient au moins l'un des matériaux suivants : Al₂O₃, AlN, ZO, FeNi, Kovar, Cu, molybdène, LCP, PPA, PEEK.

13. Dispositif de diode électroluminescente selon l'une quelconque des revendications précédentes, dans lequel le corps de refroidissement (4) contient un matériau céramique, un matériau semi-conducteur ou un composite métallique.

14. Dispositif de diode électroluminescente selon l'une quelconque des revendications précédentes, dans lequel les dimensions extérieures du dispositif de diode électroluminescente sont au maximum de 4x4x4 mm.
